# EUROPÄISCHE PATENTSCHRIFT

(11) **EP 0 635 942 B1**
(45) Veröffentlichungstag und Bekanntmachung des Hinweises auf die Patenterteilung: **20.05.1998**
(21) Anmeldenummer: 94109987.1
(22) Anmeldetag: 28.06.1994
(51) Int. Cl.: H03K 17/0416

(54) **Digitale Schaltstufe mit Stromschalter**
Digital switching stage with current switch
Etage de commutation numérique avec commutateur de courant

(30) Priorität: 28.06.1993 DE 4321482
(43) Veröffentlichungstag der Anmeldung: 25.01.1995
(73) Patentinhaber: SIEMENS AKTIENGESELLSCHAFT, 80333 München (DE)
(72) Erfinder: Wilhelm, Wilhelm, Dr.-Ing., D-81477 München (DE); Hölzle, Josef, Dipl.-Ing. (FH), D-86825 Bad Wörishofen (DE)

(56) Entgegenhaltungen:
- EP-A- 0 055 093
- WO-A-85/04774
- US-A- 4 347 446
- PATENT ABSTRACTS OF JAPAN vol. 10, no. 42 (E-382) (2099) 19. Februar 1986 & JP-A-60 198 921 (HITACHI) 8. Oktober 1985

## Beschreibung

Die Erfindung betrifft eine digitale Schaltstufe mit einem Differenzverstärker, der einen ersten und einen zweiten Differenzverstärkerzweig aufweist,
einem ersten Widerstand, der in den ersten Differenzverstärkerzweig geschaltet ist und der einen ersten Anschluß aufweist, der ein Anschluß für ein erstes Versorgungspotential ist, und einen zweiten Anschluß,
einem ersten Bipolartransistor, der bezüglich des zweiten Anschlusses des ersten Widerstandes in Emitterfolgerschaltung geschaltet ist und dessen Emitter mit einem Ausgangsanschluß verbunden ist.

Eine solche Schaltstufe ist aus der Literaturstelle George R. Wilson, "Advances in Bipolar VLSI", Proceedings of the IEEE, Band 78, Nr. 11, S. 1706 - 1719, November 1990 gezeigt. Der Ausgang der Schaltstufe ist durch die angeschlossene Verbindungsleitung im wesentlichen kapazitiv belastet. Bei einer positiv gerichteten Flanke des Ausgangssignals fließt der zur Umladung der ausgangsseitig wirkenden parasitären Kapazität benötigte Strom über den Emitterfolgertransistor. Der Umladestrom wird also niederohmig von der ersten Versorgungspotentialquelle geliefert. Bei einer negativ gerichteten Ausgangssignalflanke fließt der Umladestrom entweder über eine zusätzliche Stromquelle oder über den Eingang einer ausgangsseitig angeschlossenen weiteren Schaltstufe. Der Strom wird dabei hochohmig aus einer weiteren Versorgungspotentialquelle geliefert.

Aus dem Stand der Technik US 43 47 446 ist eine emittergekoppelte Logikschaltung gemäß Oberbegriff des Anspruchs 1 bekannt. Die differentielle Eingangsschaltung weist einen aktiven Pull-Down-Transistor sowie Komponenten auf, um den Pull-Down-Transistor nur während des High-Low-Übergangs des Ausgangssignals zu aktivieren.

Weiterhin ist aus dem Stand der Technik Patent Abstracts of Japan, Vol. 10, Nr. 42, JP-A-60 198 921 eine Schaltungsanordnung bekannt, bei der die Basis eines Transistors mit einem Spannungsteiler verbunden ist, welcher eine Widerstandsdiodenschaltung aufweist.

Um eine hohe Arbeitsgeschwindigkeit zu erreichen, müssen die Schaltstufen ausreichende Treiberfähigkeit aufweisen. Durch die zusätzliche Stromquelle bzw. die nachgeschaltete Schaltstufe fließt deshalb ein hoher Dauerstrom. Die Verlustleistung ist entsprechend hoch.

Die Aufgabe der vorliegenden Erfindung ist es, eine digitale Schaltstufe der eingangs genannten Art anzugeben, die eine hohe Verarbeitungsgeschwindigkeit bei niedriger Verlustleistung aufweist.

Diese Aufgabe wird bei der eingangs erwähnten digitalen Schaltstufe durch die im kennzeichen des Anspruchs 1 angegebenen Merkmale gelöst.

Bei der erfindungsgemäßen Schaltstufe wird sowohl für die steigende als auch die fallende Ausgangssignalflanke der Umladestrom der ausgangsseitig wirkenden parasitären Kapazität niederohmig aus den Versorgungspotentialquellen geliefert. Die Eingangs- und Ausgangssignalpegel liegen symmetrisch zu den Versorgungspotentialen. Die Versorgungsspannung liegt im Vergleich zur herkömmlichen Schaltstufe niedriger, so daß dadurch die Verlustleistung weiter verringert wird.

Im folgenden wird die Erfindung anhand der in der Zeichnung dargestellten Ausführungsbeispiele näher erläutert.
Es zeigen
Figur 1 eine erfindungsgemäße ODER-Schaltstufe und
Figur 2 ein Master-Slave-Flip Flop (nicht beansprucht).

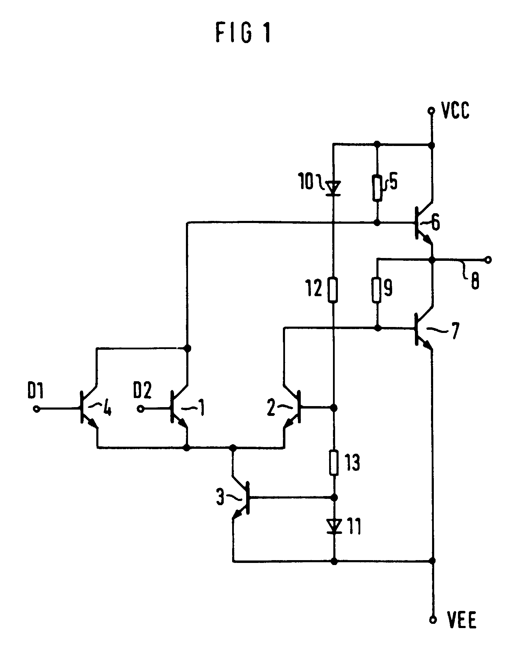

Die Schaltstufe gemäß Figur 1 enthält einen Differenzverstärker mit Schalttransistoren 1, 2, 4, deren Emitter gekoppelt sind und über die Kollektor-Emitter-Strecke eines Stromquellentransistors 3 mit einem Anschluß für ein Versorgungspotential VEE verbunden sind. Die Transistoren 1, 4 sind bezüglich ihrer Kollektor-Emitter-Strecken parallel geschaltet, so daß zwischen den an ihren Basisanschlüssen anliegenden Eingangssignalen D1, D2 eine ODER-Verknüpfung bebildet wird. In jedem der Differenzverstärkerzweige liegt ein Arbeitswiderstand 5 bzw. 9. Der Arbeitswiderstand 5 ist mit einem Anschluß für ein weiteres Versorgungspotential VCC verbunden, das bezüglich des Versorgungspotentials VEE eine positive Polarität hat. Der andere Anschluß des Widerstands 5 ist über die Basis-Emitter-Strecke eines Emitterfolgertransistors 6 mit einem Ausgangsanschluß 8 verbunden. Der Kollektor des Transistors 6 ist mit dem Anschluß für das Versorgungspotential VCC verbunden. Der Ausgangsanschluß 8 ist über die Kollektor-Emitter-Strecke eines weiteren Transistors 7 mit dem Versorgungspotential VEE verbunden. Zwischen Kollektor und Basis des Transistors 7 ist der Widerstand 9 geschaltet.

Die Transistoren 6, 7 wirken als Totem-Pole-Schaltung zwischen den Versorgungspotentialen VCC, VEE. Die Widerstände 5, 9 verhindern, daß die jeweils zugeordneten Transistoren 6 bzw. 7 in Sättigung treten. Fließt der Schaltstrom des Stromquellentransistors 3 durch einen der Widerstände 5, 9, wird das Basispotential des entsprechenden Transistors 6 bzw. 7 soweit abgesenkt, daß der Transistor gesperrt ist. Durch den jeweils anderen der Widerstände 5, 9 fließt nur der Basisstrom des zugeordneten Transistors, so daß die Kollektor-Emitter-Strecke dieses Transistors im wesentlichen als Diode wirkt. Somit liegt der H-Pegel um die Spannung einer Diodenstrecke niedriger als das positive Versorgungspotential VCC, der L-Pegel um die Spannung einer Diodenstrecke höher als das negative Versorgungspotential VEE. Die Signalpegel liegen demnach symmetrisch bezüglich der Versorgungspotentiale VCC, VEE und bezüglich der Mitte der Potentialdifferenz der Potentiale VCC, VEE.

Der Umladestrom für eine an den Anschluß 8 gelegte Kapazität wird für ein Umschalten von L nach H am Ausgang 8 über die Kollektor-Emitter-Strecke des Transistors 6 aus der Versorgungspotentialquelle VCC geliefert. Für das Umschalten von H nach L wird der Ladestrom der an den Anschluß 8 angeschlossenen Kapazität aus der Versorgungspotentialquelle VEE über die Kollektor-Emitter-Strecke des Transistors 7 geliefert. Diese Strompfade sind jeweils niederohmig.

An der Basis des Schalttransistors 2 liegt ein Referenzpotential an. Zweckmäßigerweise wird das Referenzpotential durch Spannungsteilung aus den Versorgungspotentialen VCC, VEE erzeugt. Besonders vorteilhaft ist die Realisierung mit einem zwischen die Versorgungspotentialanschlüsse geschalteten Strompfad aus einer Diode 10, zwei Widerstände 12, 13 mit gleichem Widerstandswert und einer weiteren Diode 11. Die Dioden 10, 11 sind in Flußrichtung geschaltet, wobei die Diode 10 an das positive Versorgungspotential, die Diode 11 an das negative Versorgungspotential angeschlossen ist. Der Referenzspannungsgenerator kann für mehrere, beispielsweise vier Stromschalter gemeinsam verwendet werden. Die Basis des Stromquellentransistors 3 wird dabei mit dem Anodenanschluß der Diode 11 verbunden. Somit bilden der Referenzstrompfad und die Kollektor-Emitter-Strecke des Stromquellentransistors 3 einen Stromspiegel.

Für die Dimensionierung der Widerstände 5, 9 und 12, 13 ist folgende Dimensionierung vorteilhaft. Die Widerstände 12, 13 weisen wie bereits angegeben den gleichen Widerstandswert R auf. Ferner werden die Widerstände 5, 9 jeweils gleich groß, jeweils mit dem doppelten Widerstandswert 2 ^{^{.}} R dimensioniert. Im Ruhezustand fließt dann durch die Totem-Pole-Stufe der Transistoren 6, 7 ein Strom in der Größenordnung des Schaltstroms durch den Stromquellentransistor 3 bzw. durch den Referenzstrompfad. Die Versorgungsspannung beträgt zweckmäßigerweise etwa 2V, so daß keiner der Transistoren in Sättigung betrieben wird. Da die Signalpegel symmetrisch zu den Versorgungspotentialen liegen, kann sowohl das Versorgungspotential VEE als auch das Versorgungspotential VCC als Bezugspotential (Masse) gewählt werden.

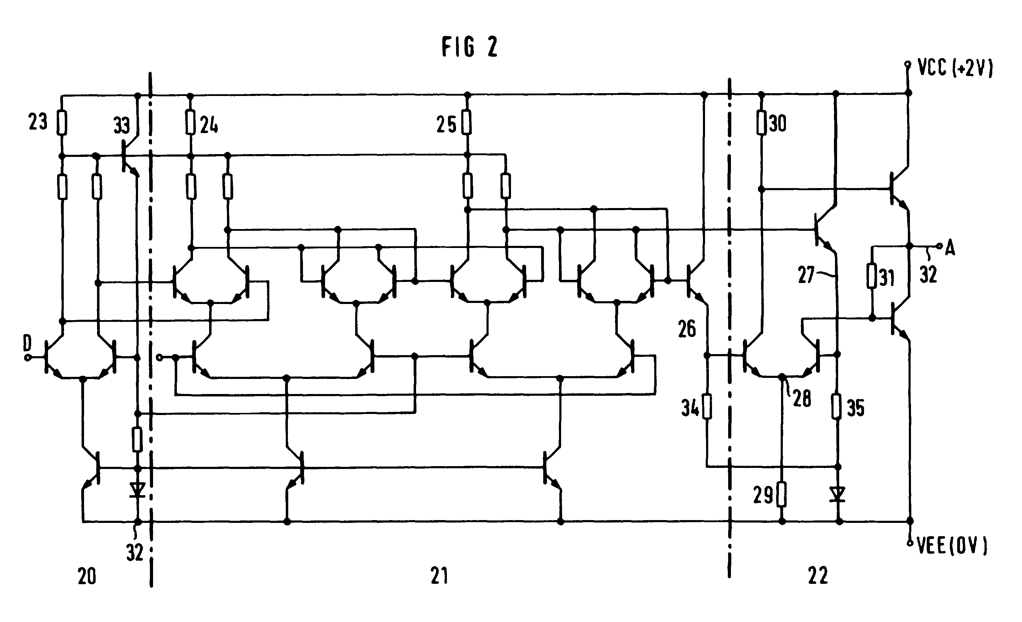

In der Figur 2 ist eine nicht beanspruchte Schaltstufe als Ausgangsstufe eines Master-Slave-Flip Flops gezeigt. Das zu speichernde Signal D wird der Eingangsstufe 20 zugeführt, der eine von einem Taktsignal CLK gesteuerte Master-Slave-Stufe 21 nachgeschaltet ist. Das Ausgangssignal der Master-Slave-Stufe 21 wird durch die Schaltstufe 22 verstärkt und auf die entsprechenden Ausgangslogikpegel umgesetzt. Die Master-Slave-Stufe 21 liefert an ihren Ausgängen 26, 27 differenzielle Signale. Deshalb bleibt der Schaltungsknoten 28 unabhängig vom Schaltungszustand stets auf dem gleichen Potential. Somit kann die den Schaltstrom für den Differenzverstärker liefernde Stromquelle sowohl als Stromquellentransistor als auch - wie gezeigt - als Widerstand 29 realisiert werden. Das Verhältnis der Arbeitswiderstände 30, 31 zum Stromquellenwiderstand 29 wird nun so eingestellt, daß sich für das Ausgangssignal A am Ausgang 32 die im Zusammenhang mit der Figur 1 beschriebenen Ausgangssignalpegel ergeben.

Durch die Auswertung der differentiellen Ausgänge 26, 27 der Master-Slave-Stufe 21 in der Ausgangsstufe 22 können die Stufen 20, 21 mit verringerten, zweckmäßigerweise halbierten Signalpegeln betrieben werden. Hierzu werden die Schaltstufen der Eingangsstufe 20 und der Master-Slave-stufe 21 über Widerstände 23, 24, 25 an das Versorgungspotential VCC gelegt. Außerdem ist im Referenzstromzweig 32 der Eingangsstufe 20 mit einem Bipolartransistor 33 vorgesehen, der als Emitterfolger bezüglich des Widerstands 23 in den Referenzstromzweig 32 geschaltet ist. Zweckmäßigerweise sind alle Widerstände der Stufen 20, 21 und die Widerstände 34, 35, über die die Ausgänge 26, 27 der Master-Slave-Stufe 21 mit Strom versorgt werden, gleich groß dimensioniert.

## Patentansprüche

1. Digitale Schaltstufe mit
einem Differenzverstärker, der einen ersten Differenzverstärkerzweig mit einem ersten Schalttransistor (1) und einen zweiten Differenzverstärkerzweig mit einem zweiten Schalttransistor (2) aufweist,
einem ersten Widerstand (5), der in den ersten Differenzverstärkerzweig geschaltet ist und der einen ersten Anschluß aufweist, der ein Anschluß für ein erstes Versorgungspotential (VCC) ist, und einen zweiten Anschluß,
einem ersten Bipolartransistor (6), der bezüglich des zweiten Anschlusses des ersten Widerstandes (5) in Emitterfolgerschaltung geschaltet ist und dessen Emitter mit einem Ausgangsanschluß (8) verbunden ist,
einem Ausgangsanschluß (8), der über die Kollektor-Emitter-Strecke eines zweiten Bipolartransistors (7) mit einem Anschluß für ein zweites Versorgungspotential (VEE) verbunden ist,
einem zweiten Widerstand (9), der einen ersten und einen zweiten Anschluß aufweist, und der in den zweiten Differenzverstärkerzweig geschaltet ist,
wobei der erste Anschluß des zweiten Widerstandes (9) mit dem Ausgangsanschluß (8) verbunden ist und
wobei der zweite Anschluß des zweiten Widerstandes (9) mit der Basis des zweiten Bipolartransistors (7) verbunden ist,
**dadurch gekennzeichnet**,
daß die Basis des zweiten Schalttransistors (2) über einen zwischen die Versorgungspotentiale (VCC, VEE) geschalteten Spannungsteiler mit einem Referenzpotential versorgt wird, daß der Spannungsteiler enthält:
eine erste Diode (10), deren Anode mit dem Anschluß für das erste Versorgungspotential (VCC) verbunden ist,
eine zweite Diode (11), deren Kathode mit dem Anschluß für das zweite Versorgungspotential (VEE) verbunden ist,
einen ersten Widerstand (12), der zwischen die Kathode der ersten Diode (10) und die Basis des zweiten Schalttransistors (2) geschaltet ist,
einen zweiten Widerstand (13), der zwischen die Basis des zweiten Schalttransistors (2) und die Anode der zweiten Diode (11) geschaltet ist,
daß der erste und der zweite Widerstand (12, 13) des Spannungsteilers einen gleichen, ersten Widerstandswert aufweisen,
daß der erste und der zweite Widerstand (5, 9) des Differenzverstärkers je einen gleichen, zweiten Widerstandswert aufweisen, der das Doppelte des ersten Widerstandswerts beträgt.

2. Digitale Schaltstufe nach Anspruch 1,
**dadurch gekennzeichnet,**
daß die Emitter der Schalttransistoren (1, 2) gekoppelt sind und über die Kollektor-Emitter-Strecke eines Stromquellentransistors (3) mit dem Anschluß für das zweite Versorgungspotential (VEE) verbunden sind.

3. Digitaler Stromschalter nach Anspruch 2,
**dadurch gekennzeichnet,**
daß die Basis des Stromquellentransistors (3) mit der Anode der zweiten Diode (11) verbunden ist.

## Claims

1. Digital switching stage having
a differential amplifier, which has a first differential amplifier path having a first switching transistor (1) and a second differential amplifier path having a second switching transistor (2),
a first resistor (5), which is connected into the first differential amplifier path and has a first terminal, which is a terminal for a first supply potential (VCC), and a second terminal,
a first bipolar transistor (6), which is connected in an emitter follower circuit with respect to the second terminal of the first resistor (5) and whose emitter is connected to an output terminal (8),
an output terminal (8), which is connected via the collector-emitter path of a second bipolar transistor (7) to a terminal for a second supply potential (VEE),
a second resistor (9), which has a first and a second terminal and is connected into the second differential amplifier path,
the first terminal of the second resistor (9) being connected to the output terminal (8), and
the second terminal of the second resistor (9) being connected to the base of the second bipolar transistor (7),
characterized
in that the base of the second switching transistor (2) is supplied with a reference potential via a voltage divider connected between the supply potentials (VCC, VEE),
in that the voltage divider contains:
a first diode (10), whose anode is connected to the terminal for the first supply potential (VCC),
a second diode (11), whose cathode is connected to the terminal for the second supply potential (VEE),
a first resistor (12), which is connected between the cathode of the first diode (10) and the base of the second switching transistor (2),
a second resistor (13), which is connected between the base of the second switching transistor (2) and the anode of the second diode (11),
in that the first and the second resistor (12, 13) of the voltage divider have an identical, first resistance,
in that the first and the second resistor (5, 9) of the differential amplifier each have an identical, second resistance which is double the first resistance.

2. Digital switching stage according to Claim 1,
characterized
in that the emitters of the switching transistors (1, 2) are coupled and are connected via the collector-emitter path of a current source transistor (3) to the terminal for the second supply potential (VEE).

3. Digital current switch according to Claim 2,
characterized
in that the base of the current source transistor (3) is connected to the anode of the second diode (11).

## Revendications

1. Etage de commutation numérique comprenant
un amplificateur différentiel formé par une première branche d'amplificateur différentiel avec un premier transistor de commutation (1) et une seconde branche d'amplificateur différentiel avec un second transistor de commutation (2),
une première résistance (5) qui est branchée dans la première branche de l'amplificateur différentiel et est pourvue d'une première borne qui est une borne pour un premier potentiel d'alimentation (VCC) et d'une seconde borne,
un premier transistor bipolaire (6) qui est monté en émetteur-suiveur par rapport à la seconde borne de la première résistance (5) et dont l'émetteur est relié à une borne de sortie (8),
une borne de sortie (8) qui est reliée à une borne pour un second potentiel d'alimentation (VEE) par le biais du trajet collecteur-émetteur d'un second transistor bipolaire (7),
une seconde résistance (9) qui est pourvue d'une première et d'une seconde bornes et qui est branchée dans la seconde branche de l'amplificateur différentiel,
la première borne de la seconde résistance (9) étant reliée à la borne de sortie (8) et
la seconde borne de la seconde résistance (9) étant reliée à la base du second transistor bipolaire (7),
caractérisé en ce que la base du second transistor de commutation (2) est alimentée avec un potentiel de référence par le biais d'un réducteur de tension branché entre les potentiels d'alimentation (VCC, VEE), en ce que le réducteur de tension contient:
une première diode (10) dont l'anode est reliée à la borne pour le premier potentiel d'alimentation (VCC),
une seconde diode (11) dont la cathode est reliée à la borne pour le second potentiel de référence (VEE),
une première résistance (12) qui est branchée entre la cathode de la première diode (10) et la base du second transistor de commutation (2),
une seconde résistance (13) qui est branchée entre la base du second transistor de commutation (2) et l'anode de la seconde diode (11),
en ce que les première et seconde résistances (12, 13) du réducteur de tension ont une première valeur de résistance identique,
en ce que les première et seconde résistances (5, 9) de l'amplificateur différentiel ont toutes les deux une seconde valeur de résistance identique qui est égale au double de la première valeur de résistance.

2. Etage de commutation numérique selon la revendication 1, caractérisé en ce que les émetteurs des transistors de commutation (1, 2) sont couplés et sont reliés à la borne pour le second potentiel d'alimentation (VEE) par le biais du trajet collecteur-émetteur d'un transistor source de courant (3).

3. Commutateur de courant selon la revendication 2, caractérisé en ce que la base du transistor source de courant (3) est reliée à l'anode de la seconde diode (11).
